Europäisches Patentamt

(19) European Patent Office

Office européen des brevets

(11) Numéro de publication : **0 149 932**
**B1**

(12) **FASCICULE DE BREVET EUROPÉEN**

(45) Date de publication du fascicule du brevet :
19.08.87

(21) Numéro de dépôt : **84402372.1**

(22) Date de dépôt : **21.11.84**

(51) Int. Cl.⁴ : **H 05 K** 1/16, H 01 L 29/80

(54) Support pour composant rapide, notamment composant hyperfréquence, à éléments de découplage incorpores.

(30) Priorité : **22.11.83 FR 8318571**

(43) Date de publication de la demande :
**31.07.85 Bulletin 85/31**

(45) Mention de la délivrance du brevet :
**19.08.87 Bulletin 87/34**

(84) Etats contractants désignés :
**DE GB IT NL**

(56) Documents cités :
**FR-A- 1 582 263**
**FR-A- 2 471 726**

(73) Titulaire : **INTERCONNEXIONS CERAMIQUES S.A.**
**Tour Manhattan 6, place de l'Iris La Défense**
**F-92400 Courbevoie (FR)**

(72) Inventeur : **Dubuisson, Jacques**
**22, Avenue Emile Zola**
**F-75015 Paris (FR)**
Inventeur : **Le Gal, Pascal**
**4, rue de Paris**
**F-77450 Magny le Hongre (FR)**

(74) Mandataire : **Martin, Jean-Jacques et al**
**Cabinet REGIMBEAU 26, Avenue Kléber**
**F-75116 Paris (FR)**

## Description

La présente invention concerne un support pour composant rapide.

Elle s'applique à tous les dispositifs rapides, notamment les composants hyperfréquences et les transistors bipolaires ou à effet de champ, tout particulièrement ceux réalisés sur substrat d'arséniure de gallium. Ces composants nécessitent, du fait de la fréquence de travail élevée, un découplage très soigné de certaines de leurs électrodes — par exemple la ou les sources dans le cas d'un transistor à effet de champ —, ce qui suppose de prévoir des capacités à un emplacement le plus proche possible de ces électrodes à découpler pour éviter tout effet inductif dû à une connexion trop longue, qui ferait perdre au dispositif ses avantages de rapidité.

Il est par contre nécessaire d'éviter tout couplage capacitif entre les différentes électrodes du composant — par exemple entre le drain et la grille, ou entre les deux sources, dans l'exemple précité — : en hyperfréquences, le taux d'amplification diminue en effet très rapidement dès que cette capacité parasite atteint quelques picofarads.

Dans la pratique, on utilise soit des supports à forte constante diélectrique dont les capacités parasites entre électrodes limitent les performances en fréquence, soit des supports à faible constante diélectrique qui ne procurent pas un découplage suffisant, et auxquels il est nécessaire d'associer des éléments capacitifs rapportés, avec des connexions supplémentaires qui compliquent la réalisation et risquent de produire des effets inductifs.

Pour s'affranchir de ces inconvénients, l'invention propose un support qui à la fois assure un excellent découplage de certaines des électrodes et évite tout couplage capacitif entre les électrodes du composant. Ce support est du type formé par un bloc fritté de feuilles empilées de céramique ayant une constante diélectrique supérieure à 1 000 ; il est apte à recevoir des métallisations superficielles formant connexions de raccordement aux bornes du composant.

Selon l'invention, il comprend une zone centrale émergeant en surface du support, s'étendant sensiblement au droit de l'emplacement du composant supporté, et formée d'un matériau ayant une constante diélectrique inférieure à 100 ; il est par ailleurs prévu hors de la zone centrale et à la périphérie de celle-ci, sous la surface du support et à faible profondeur, au moins une métallisation interne formée par un motif conducteur porté par l'une des feuilles de l'empilement et relié à une connexion de masse, la métallisation interne et l'une des métallisations superficielles ayant des surfaces en regard de manière à constituer un condensateur de découplage pour la borne du composant à laquelle est reliée cette métallisation superficielle.

Bien entendu, l'invention concerne aussi bien le support déjà pourvu des métallisations superficielles, c'est-à-dire prêt à recevoir le composant, que le support dépourvu de ces métallisations. On verra en effet par la suite que le dépôt de ces métallisations n'est pas nécessairement effectué au cours du processus de fabrication du support ; en effet, dans certains cas, l'utilisateur peut préférer effectuer lui-même le dépôt des métallisations, ceci pour leur donner une forme et les disposer sur le support d'une façon particulière, appropriée à tel ou tel besoin particulier.

Dans un premier mode de réalisation, le matériau ayant une constante diélectrique inférieure à 100, est un vitrocérame, c'est-à-dire un verre cristallisé à bas point de fusion, chargé en matériau diélectrique. Ce vitrocérame est choisi de manière à être compatible avec la céramique diélectrique sous contrainte mécanique et thermique.

Dans un second mode de réalisation, le matériau ayant une constante diélectrique inférieure à 100 est une céramique à base de titanate de magnésie, qui a des propriétés de frittabilité voisines du diélectrique ayant constante diélectrique supérieure à 1 000, et est aussi compatible, après frittage, sous contrainte thermique et mécanique.

Par ailleurs, avantageusement, la céramique ayant une constante diélectrique supérieure à 1 000 est une céramique à base de titanate de baryum avec addition, par exemple, d'oxydes de praséodyme et de néodyme.

L'invention concerne également un procédé de fabrication d'un tel support, comportant les étapes de :

empilage de feuilles de céramique crue ayant une constante diélectrique supérieure à 1 000 et dont l'une au moins comprend un motif conducteur, la dernière feuille de la pile au moins étant une feuille de céramique d'épaisseur appropriée pour former un diélectrique,

compression et séchage de l'empilement,

perçage de trous, borgnes ou traversants, à l'emplacement de chaque zone destinée à supporter un composant rapide de manière à y former un alvéole,

première cuisson de la céramique,

remplissage de l'alvéole par un matériau, verre ou céramique, ayant une constante diélectrique inférieure à 100,

seconde cuisson du matériau de remplissage,

rectification,

polissage,

découpe en supports unitaires.

0 149 932

Avantageusement, l'étape de première cuisson est remplacée par une co-cuisson unique, au moment de la seconde cuisson, de la céramique et du matériau de remplissage. Cette variante est particulièrement avantageuse dans le cas où le matériau ayant une constante diélectrique inférieure à 100 est une céramique ;

D'autres caractéristiques et avantages de l'invention apparaîtront à la lecture de la description détaillée ci-dessous, faite en référence aux dessins annexés, sur lesquels :

la figure 1 montre schématiquement, en plan, la disposition des électrodes de connexion au composant, dans le cas d'un support de type classique,

la figure 2 est une vue en coupe, selon la ligne II-II de la figure 3, du support selon l'invention,

la figure 3 est une vue en plan, selon la ligne III-III de la figure 2, de ce même support,

les figures 4 à 6 illustrent les étapes de formation de l'empilement des feuilles de céramique et de percement de cet empilement,

la figure 7 est une variante de la figure 6, dans le cas d'une prise de connexion au moyen de trous métallisés,

les figures 8 et 9 montrent en perspective, respectivement vu de dessus et de dessous, le composant réalisé selon cette dernière variante,

la figure 10 est une vue en coupe, homologue de la figure 2, du composant obtenu selon cette même variante,

la figure 11 est similaire à la figure 10, pour une autre variante de réalisation.

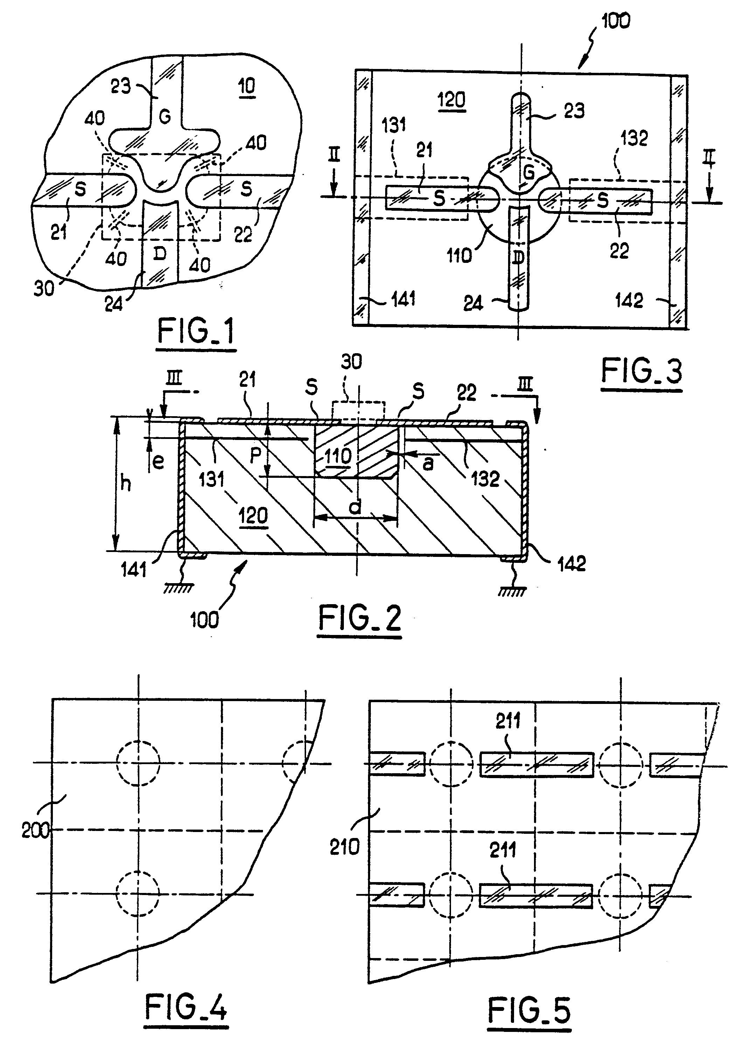

Sur la figure 1, on a représenté, vues en plan, les connexions 21 à 24 déposées à la surface d'un substrat 10 de type classique, le composant 30 à relier étant figuré en tiretés.

Ici dans la suite, on prendra l'exemple d'un transistor à effet de champ, bien que cet exemple ne soit aucunement limitatif. Les deux électrodes 21 et 22 sont alors les électrodes reliant les sources du transitor, les électrodes 23 et 24 reliant respectivement la grille et le drain.

Si l'on utilise pour le support 10 une céramique de forte constante diélectrique, et si l'on prévoit à l'intérieur de ce support une électrode interne reliée à la masse (non représentée), on pourra assurer un bon découplage des deux sources, c'est-à-dire des deux électrodes 21 et 22 par une disposition appropriée de cette électrode interne de manière à disposer d'une capacité de l'ordre de 10 à 60 pF selon la fréquence de travail.

Par contre, on ne pourra pas éviter l'apparition de capacités parasites, figurées en 40, entre les différentes électrodes. Ces capacités parasites sont inhérentes à la forte constante diélectrique du matériau utilisé et, dès qu'elles dépassent quelques picofarads, elles réduisent grandement les performances du composant une fois monté sur son support.

Pour pallier cet inconvénient, l'invention propose un support 100, représenté figures 2 et 3 respectivement en coupe et en plan, composé d'un bloc fritté 120 de céramique de forte constante diélectrique, au centre duquel est prévue une zone centrale 110, émergente, s'étendant sensiblement au droit de l'emplacement 30 du composant qui sera supporté, et formé d'un matériau de faible constante diélectrique.

Ici dans la suite, on entendra généralement par « faible constante diélectrique » une constante inférieure à 100, et par « forte constante diélectrique » une constante supérieure à 1 000.

Pour assurer le découplage des électrodes superficielles 21 et 22 (correspondant aux électrodes de connexion aux sources du transistor), on prévoit, dans la région à forte constante diélectrique, des électrodes 131, 132 à faible profondeur e sous la surface du substrat, ces électrodes internes 131, 132 ayant des surfaces en regard avec les électrodes superficielles 21, 22 (comme on peut le voir figure 3) de manière à constituer, pour chacune des sources, les deux électrodes d'un condensateur de découplage ; les électrodes 131 et 132 sont par ailleurs reliées à la masse par une ou plusieurs connexions 141, 142 en forme de métallisation externe du composant.

Les électrodes internes 131 et 132 sont par exemple formées par un motif conducteur porté par l'une des feuilles de l'empilement du bloc fritté.

Dans un exemple de réalisation, les dimensions du support sont les suivantes : hauteur h = 1,2 mm ; diamètre de la zone centrale d = 0,9 mm ; profondeur de la zone centrale p = 0,4 mm ; épaisseur de la couche diélectrique formant condensateur e = 50 $\mu$m ; espace de garde des électrodes par rapport à la zone centrale a = 0,3 mm. La largeur et la longueur des électrodes internes 131, 132 sont choisies en fonction de la capacité de découplage désirée ; les dimensions et la forme des électrodes superficielles 21-24 sont choisies de manière à minimiser les capacités parasites et les effets inductifs.

Un tel exemple de support convient aux composants hyperfréquences en forme de puce de dimensions 0,3 $\times$ 0,3 mm en particulier.

En ce qui concerne la céramique à forte constante diélectrique, on choisit de préférence une céramique à base de titanate de baryum avec addition d'oxydes de praséodyme et de néodyme.

La composition suivante, qui possède une constante diélectrique de 2 700 à 1 kHz convient particulièrement dans le cas présent :

0,897 $TiO_2$ + 0,875 BaO + 0,021 $Nb_2O_5$ + 0,012 $PrO_2$ + 0,012 CaO + 0,006 $Nd_2O_3$ (proportions en moles);

avec additifs alumine et silice.

3

En ce qui concerne le matériau à faible constante diélectrique, on utilise dans un mode de réalisation préférentiel un vitrocérame, c'est-à-dire un verre cristallisé à bas point de fusion, chargé en matériau diélectrique. Un matériau convenable dans l'application souhaitée est par exemple composé de 40 à 65 % en poids de borosilicate de plomb, 5 à 25 % en poids d'oxyde de bismuth, et 3 à 30 % en poids d'oxyde de titane ou d'oxyde de cadmium. Un tel matériau possède une température de fusion et un coefficient de dilatation proches de ceux de la céramique à forte constante diélectrique, ce qui assure sa parfaite compatibilité avec cette dernière.

Du point de vue diélectrique, un tel vitrocérame présente une constante d'environ 2,4 à 1 kHz, permettant donc d'éviter toute apparition de capacités parasites entre les différentes électrodes du composant.

Dans un autre mode de réalisation, le matériau à faible constante diélectrique est une céramique à base de titanate de magnésie.

La formule suivante est particulièrement appropriée :

$$TiO_2 + 0,83\ MgO + 0,14\ BaO + 0,16\ ZnO + 0,05\ ZrO_2 + 0,04\ CaO \text{ (proportions en moles) et traces de silice et alumine;}$$

Cette céramique présente une constante diélectrique de 25 à 1 hKz. Elle est par ailleurs compatible, du point de vue retrait et température de cuisson, avec la céramique à haute constante diélectrique utilisée par ailleurs.

On va maintenant décrire un procédé de fabrication du support selon l'invention.

Tout d'abord, on procède à l'empilement des feuilles unitaires de céramique crue (d'épaisseur 50 μm environ chacune, en cru) ; on ajoute ainsi successivement : n feuilles telle que celle représentée en 200 figure 4 ; une feuille telle que celle représentée en 210 figure 5, pourvue de métallisations 211 qui constitueront les armatures internes des capacités ; enfin, une ou plusieurs feuilles de céramique morte identiques aux feuilles 200, pour former une épaisseur convenable pour constituer le diélectrique de la capacité de découplage. Sur les figures 4 et 5, on a représenté en tiretés l'emplacement futur de la zone centrale, ainsi que les traits de découpe des feuilles qui permettront de séparer les supports individuels.

Dans une seconde étape, on comprime et on sèche l'empilement de feuilles de céramique crue, de manière classique,

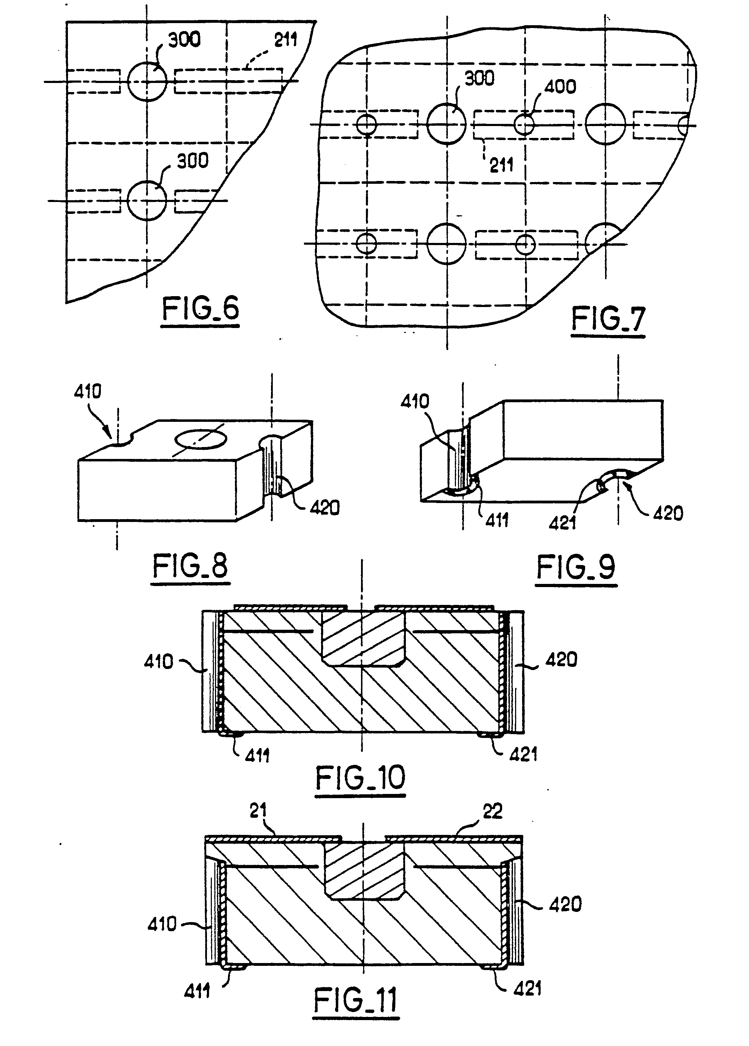

Après cette étape, on perce des trous, borgnes ou traversants, à l'emplacement de la zone centrale de chacun des supports individuels, de manière à y former un alvéole. Sur la figure 6, cet alvéole est représenté en 300, les motifs conducteurs 211 étant désormais noyés à l'intérieur de la céramique.

Ensuite on procède à une première cuisson à haute température de la céramique, par exemple à 1 267 °C pour la composition de céramique indiquée plus haut.

L'étape suivante consiste à remplir les alvéoles 300, soit au moyen d'un vitrocérame, soit au moyen d'une céramique, l'un ou l'autre matériau ayant une constante diélectrique la plus faible possible et un cœfficient de dilatation adapté à celui de la céramique de forte constante diélectrique.

On procède ensuite à une seconde cuisson, à basse température (de l'ordre de 750°) du matériau de remplissage.

Le bloc est ensuite rectifié, de manière à lui donner une bonne planéité et ajuster avec précision l'épaisseur e qui constituera le diélectrique des condensateurs de découplage. Cette étape est suivie d'une opération de polissage du bloc.

Enfin, les supports unitaires sont individualisés par découpe, par exemple à la scie.

Pour chacun des supports individuels, on procède alors à la mise en place des métallisations externes, par exemple par trempage des extrémités du bloc dans une laque conductrice, qui est ensuite séchée et durcie.

Dans une variante avantageuse du procédé, notamment appropriée au mode de réalisation où le matériau à faible constante diélectrique est une céramique, l'étape de première cuisson est supprimée et remplacée par une co-cuisson unique (au moment de la seconde cuisson du cas précédent) des deux céramiques ; celles-ci sont alors choisies de manière à avoir même retrait et même température de cuisson.

Par ailleurs, il a été indiqué que l'alvéole formant la zone centrale a été réalisé par perçage avant cuisson, mais d'autres techniques sont envisageables (par exemple au jet de sable ou au laser), qui pourraient d'ailleurs amener à des formes d'alvéole différentes de celle représentée sur les figures (par exemple alvéole tronconique pour une érosion au jet de sable).

Par ailleurs, si l'on souhaite réaliser des supports déjà pourvus des métallisations superficielles de connexion aux électrodes du composant, on peut réaliser collectivement celles-ci par évaporation sous vide ou pulvérisation cathodique puis attaque chimique après masquage, entre les étapes de polissage et de découpe des éléments unitaires.

Par ailleurs, il est possible, également si on le souhaite, de monter collectivement, à ce moment, les puces de composant sur le substrat, avant de découper celui-ci en éléments unitaires.

Les figures 7 à 10 se réfèrent à une variante de réalisation des métallisations externes formant la connexion de masse : on peut avantageusement, au lieu de métalliser une ou plusieurs des faces latérales

4

du bloc, assurer la prise de connexion à l'électrode interne 211 par un trou débouchant 400 (mais qui peut également être borgne, le perçage étant effectué depuis la face inférieure du support) réalisé en même temps que l'alvéole 300, et métallisé dans une étape ultérieure.

La découpe des éléments unitaires peut par exemple se faire au droit des trous métallisés, comme représenté figure 7. On obtient alors le composant représenté figures 8 et 9, où la connexion de masse se fait par deux encoches semi-cylindriques latérales 410, 420. De préférence, la métallisation de ces encoches est prolongée sur la face inférieure de manière à former sur celle-ci un retour 411, 421 (figures 9 et 10) facilitant la prise de connexion.

En variante, le trou peut être borgne (figure 11), ce qui permet de prolonger les électrodes superficielles 21, 22 jusqu'au bord du support.

**Revendications**

1. Un support (100) pour composant (30) rapide, notamment composant hyperfréquence, en forme de bloc fritté de feuilles empilées de céramique ayant une constante diélectrique supérieure à 1000, apte à recevoir des métallisations superficielles (21-24) formant connexions de raccordement aux bornes du composant, caractérisé en ce qu'il comprend une zone centrale (110) émergeant en surface du support, s'étendant sensiblement au droit de l'emplacement du composant (30) supporté, et formée d'un matériau ayant une constante diélectrique inférieure à 100, et en ce qu'il est prévu, hors de la zone centrale et à la périphérie de celle-ci, sous la surface du support et à faible profondeur (e), au moins une métallisation interne (131, 132) formée par un motif conducteur porté par l'une des feuilles de l'empilement et relié à une connexion de masse (141, 142), la métallisation interne (131 ; 132) et l'une des métallisations superficielles (21 ; 22) ayant des surfaces en regard de manière à constituer un condensateur de découplage pour la borne du composant à laquelle est reliée cette métallisation superficielle.

2. Un support selon la revendication 1, caractérisé en ce que la connexion de masse est formée par une métallisation (141, 142) réalisée sur toute la hauteur de l'une des faces latérales du bloc, et électriquement reliée au motif conducteur par une partie ce celui-ci émergeant sur cette face.

3. Un support selon la revendication 1, caractérisé en ce que la connexion de masse est formée par une métallisation d'un trou (410, 420) ou d'une partie d'un trou, borgne ou traversant, pratiqué dans le bloc, et traversant le motif conducteur.

4. Un support selon la revendication 3, caractérisé en ce que la métallisation (410, 420) est prolongée de manière à déborder (411, 412) sur la face inférieure du substrat.

5. Un support selon la revendication 1, caractérisé en ce que le matériau ayant une constante diélectrique inférieure à 100 est un vitrocérame.

6. Un support selon la revendication 1, caractérisé en ce que le matériau ayant une constante diélectrique inférieure à 100 est une céramique à base de titanate de magnésie.

7. Un support selon la revendication 1, caractérisé en ce que la céramique ayant une constante diélectrique supérieure à 1 000 est une céramique à base de titanate de baryum.

8. Procédé de fabrication d'un support selon la revendication 1, caractérisé en ce qu'il comprend les étapes de :
empilage de feuilles de céramique crue (200, 210) ayant une constante diélectrique supérieure à 1 000 et dont l'une au moins (210) comprend un motif conducteur (211), la dernière feuille de la pile au moins étant une feuille de céramique d'épaisseur appropriée pour former un diélectrique,
compression et séchage de l'empilement,
perçage de trous (300), borgnes ou traversants, à l'emplacement de chaque zone destinée à supporter un composant rapide, de manière à y former un alvéole,
première cuisson de la céramique,
remplissage de l'alvéole par un matériau, verre ou céramique, ayant une constante diélectrique inférieure à 100,
seconde cuisson du matériau de remplissage,
rectification,
polissage,
découpe en supports unitaires.

9. Procédé selon la revendication 8, caractérisé en ce que l'étape de première cuisson est remplacée par une co-cuisson unique, au moment de la seconde cuisson, de la céramique et du matériau de remplissage.

10. Procédé selon la revendication 8, pour la réalisation d'un support selon la revendication 3, caractérisé en ce qu'il comprend, avant polissage, une étape de percement des trous (400) destinés à former la connexion de masse, ainsi qu'une étape de métallisation de ces trous.

11. Procédé selon la revendication 10, caractérisé en ce que la découpe des supports unitaires se fait au droit des trous métallisés.

**Claims**

**0 149 932**

1. Support (100) for a fast-acting component (30), especially a hyperfrequency component, in the form of a calcined block of stacked ceramic sheets having a dielectric constant greater than 1000 capable of receiving surface metal coatings (21-24) which form connections to the terminals of the component, characterised in that it comprises a central zone (110) which emerges into a support surface and extends substantially at right angles to the location of the supported component (30) and is formed from a material having a dielectric constant less than 100, and outside the central zone and on the periphery of the latter, below the surface of the support and at a shallow depth (e) at least one internal metal coating (131, 132) is provided which is formed from a conductive design borne by one of the sheets of the stack and coupled to an earth connection (141, 142), the internal metal coating (131, 132) and one of the surface coatings (21 ; 22) having opposing surfaces in such a way as to constitute a decoupling capacitor for the terminal of the component to which this surface metal coating is connected.

2. Support as claimed in claim 1, characterised in that the earth connection is formed by a metal coating (141, 142) applied over all the height of one of the lateral faces of the block and electrically connected to the conductive design by a part of the latter which emerges on that face.

3. Support as claimed in claim 1, characterised in that the earth connection is formed by metal coating of a hole (410, 420) or of a part of a recessed or through hole made in the block and passing through the conductive design.

4. Support as claimed in claim 3, characterised in that the metal coating (410, 420) is extended so as to project (411, 412) over the lower face of the substrate.

5. Support as claimed in claim 1, characterised in that the material having a dielectric constant less than 100 is a vitreous ceramic.

6. Support as claimed in claim 1, characterised in that the material having a dielectric constant less than 100 is a ceramic based on magnesia titanate.

7. Support as claimed in claim 1, characterised in that the material having a dielectric constant greater than 1 000 is a ceramic based on barium titanate.

8. Method of manufacturing a support as claimed in claim 1, characterised in that it comprises the following steps :

stacking unfired ceramic sheets (200, 210) which have a dielectric constant greater than 1 000 and of which at least one (210) comprises a conductive design (211), the last sheet of the pile at least being a ceramic sheet of appropriate thickness to form a dielectric,

compression and drying of the stack,

piercing of recessed or through holes (300) at the location of each zone intended to support a fast-acting component in such a way as to form a cavity there,

first firing of the ceramic,

filling the cavity with a material, glass or ceramic, having a dielectric constant less than 100,

second firing of the filler material,

rectification,

polishing,

cutting out into unit supports.

9. Method as claimed in claim 8, characterised in that the first firing stage is replaced by one single combined firing, at the time of the second firing, of the ceramic and the filler material.

10. Method as claimed in claim 8 for the production of a support as claimed in claim 3, characterised in that before the polishing stage it includes a stage of piercing holes (400) intended to form the earth connection as well as a stage of metal coating these holes.

11. Method as claimed in claim 10, characterised in that the unit supports are cut out at right angles to the metal-coated holes.

**Patentansprüche**

1. Unterlage (100) für eine schnellreagierende Komponente, insbesondere hochfrequente Komponente, in der Form eines gesinterten Blocks aus aufeinandergeschichteten Blättchen aus Keramikmaterial, welches eine dielektrische Konstante von mehr als 1 000 aufweist und Oberflächenmetallisierungen (21-24) aufnehmen kann, die Anschlußverbindungen mit den Klemmen der Komponente bilden, dadurch gekennzeichnet, daß die Komponente einen bis zu der Oberfläche der Unterlage heraufreichenden Mittenbereich (110) aufweist, der sich im wesentlichen gerade verlaufend an der Stelle der zu stützenden Komponente (30) erstreckt und aus einem Material mit einer kleineren Dielektrizitätskonstante als 100 gebildet ist, und daß außerhalb des Mittenbereiches und an dessen Umfang unter der Oberfläche der Unterlage und in geringer Tiefe (e) wenigstens eine innere Metallisierung (131, 132) vorgesehen ist, die als ein von einem der Blättchen der Aufschichtung getragenes Leitermuster gebildet und mit einer Masseverbindung (141, 142) verbunden ist, wobei die innere Metallisierung (131-132) und eine der Oberflächenmetallisierungen (21 ; 22) derart einander gegenüberliegende Flächen aufweisen, daß ein Entkopplungskondensator für die Klemme der Komponente gebildet wird, mit der diese Oberflächenmetallisierung verbunden ist.

6

2. Unterlage nach Anspruch 1, dadurch gekennzeichnet, daß die Masseverbindung mittels einer Metallisierung (141, 142) gebildet ist, die über die gesamte Höhe einer der Seitenflächen des Blocks ausgeführt und elektrisch mit dem Leitermuster über einen Teil derselben verbunden ist, der auf diese Seite heraustritt.

3. Unterlage nach Anspruch 1, dadurch gekennzeichnet, daß die Masseverbindung durch Metallisierung eines Loches (410, 420) oder eines Teils eines blinden oder Hindurchgehenden Loches gebildet ist, welches in dem Block hergestellt ist und das Leitermuster durchquert.

4. Unterlage nach Anspruch 3, dadurch gekennzeichnet, daß die Metallisierung (410, 420) derart verlängert ist, daß sie die Unterseite der Unterlage übergreift (411, 412).

5. Unterlage nach Anspruch 1, dadurch gekennzeichnet, daß das Material mit einer Dielektrizitätskonstante von weniger als 100 ein Glaskeramikmaterial ist.

6. Unterlage nach Anspruch 1, dadurch gekennzeichnet, daß das Material mit einer Dielektrizitätskonstante von weniger als 100 ein Keramikmaterial auf der Basis von Magnesiumtitanat ist.

7. Unterlage nach Anspruch 1, dadurch gekennzeichnet, daß das keramische Material mit einer Dielektrizitätskonstante von mehr als 1 000 ein keramisches Material auf der Basis von Bariumtitanat ist.

8. Verfahren zur Herstellung einer Unterlage nach Anspruch 1, dadurch gekennzeichnet, daß es die Schritte umfaßt :

Aufeinanderschichten von grünen, keramischen Blättchen (200, 210), die eine Dielektrizitätskonstante von mehr als 1 000 aufweisen und von denen wenigstens eines (210) ein Leitermuster (211) aufweist, wobei wenigstens das letzte Blättchen der Aufschichtung ein Blättchen aus Keramik mit einer geeigneten Dicke ist, um eine Dielektrikum zu bilden,

Zusammenpressen und Trocknen der Aufschichtung,

Bohren von blinden oder hindurchgehenden Löchern (300) an der Stelle eines jeden Bereiches, der zum Tragen einer schnellreagierenden Komponente bestimmt ist, derart, daß dort eine Zelle gebildet wird,

erstes Brennen der Keramik,

Füllen der Zelle mit einem Glas- oder Keramikmaterial, welches eine Dielektrizitätskonstante von weniger als 100 besitzt,

zweites Brennen des Füllmaterials,

Schleifen,

Polieren,

Zerschneiden in Einheitsunterlagen.

9. Verfahren nach Anspruch 8, dadurch gekennzeichnet, daß der Schritt des ersten Brennens durch ein einziges, gemeinsames Brennen zum Zeitpunkt des zweiten Brennens des Keramikmaterials und des Füllmaterials ersetzt wird.

10. Verfahren nach Anspruch 8 zum Herstellen einer Unterlage nach Anspruch 3, dadurch gekennzeichnet, daß es vor dem Polieren einen Schritt zum Bohren von Löchern (400), die zum Bilden der Masseverbindung bestimmt sind, sowie einen Metallisierungsschritt dieser Löcher umfaßt.

11. Verfahren nach Anspruch 10, dadurch gekennzeichnet, daß das Zerschneiden in Einzelunterlagen geradlinig der metallisierten Löcher erfolgt.

FIG.1

FIG.2

FIG.3

FIG.4

FIG.5

FIG_6

FIG_7

FIG_8

FIG_9

FIG_10

FIG_11